(19)

Europäisches
Patentamt
European
Patent Office
Office européen
des brevets

(11) **EP 1 962 430 A1**

(12) **EUROPEAN PATENT APPLICATION**

(43) Date of publication:
**27.08.2008 Bulletin 2008/35**

(51) Int Cl.:
***H03M 13/29*** *(2006.01)*    *H04L 1/00* *(2006.01)*

(21) Application number: **07290233.1**

(22) Date of filing: **22.02.2007**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK RS**<br><br>(71) Applicants:<br>• **Samsung Electronics (UK) Limited**<br>  **Chertsey,**<br>  **Surrey KT16 0PS (GB)**<br>• **Centre National de la Recherche Scientifique**<br>  **75794 Paris Cedex 16 (FR)** | (72) Inventors:<br>• **Lestable, Thierry c/o Samsung Elec. Research Inst.**<br>  **Middlese, TW18 4QE (GB)**<br>• **Poulliat, Charly**<br>  **8051 Cergy-Pontoise (FR)**<br>• **Declercq, David**<br>  **8051 Cergy-Pontoise (FR)**<br><br>(74) Representative: **Musker, David Charles et al**<br>  **R.G.C. Jenkins & Co.**<br>  **26 Caxton Street**<br>  **London SW1H 0RJ (GB)** |

(54) **Coding/Decoding**

(57)    A method and apparatus is provided for encoding and/or decoding at least one data packet using a decoding algorithm based on Belief Propagation. The data packet can be encoded, and then processed according to a permutation either before transmission at a transmitter 101 or after Soft-Demapping at a receiver 103. Decoding the received processed data packet is performed using a decoding algorithm based on the Belief Propagation algorithm and linear matrix operations. Alternatively, a method and apparatus is provided in which a data packet is encoded and transmitted to a receiver 103. The receiver 103 processes or stores a binary parity check matrix of the encoding scheme used in encoding the data packet, where the processing includes linear matrix operations, and a decoder 120 decodes the received encoded data packet based on a Belief Propagation algorithm and the processed binary parity check matrix.

FIG. 1

EP 1 962 430 A1

**Description**

FIELD OF THE INVENTION

The present invention relates to forward error correction coding and decoding schemes for communications systems. More explicitly the invention relates to methods and apparatuses for encoding and decoding data packets by pre-processing either the encoded data and the binary parity check matrix of the code used at a transmitter of a communications device or a receiver of a communications device, respectively, and using a processed binary parity check matrix in a decoding algorithm based on Belief Propagation.

BACKGROUND

The classical turbo-decoder is based on iterations of BCJR/Forward-Backward algorithms with bit (de-)interleaving between the BCJR steps. The Turbo decoder that is based on the BCJR algorithm is also known as a Belief propagation based decoder. Belief propagation is known as an algorithm that computes locally the Bayes rule on a Factor Graph (also called a Bayesian network) representation of a probabilistic model. In order to decode Turbo Codes, the BP based decoding algorithms operate on the Factor Graph representation of the Turbo Code that includes the hidden states as nodes, for more details see McEliece, Robert J. and MacKay, David J. C. and Cheng, Jung-Fu (1998) "Turbo decoding as an instance of Pearl's "belief propagation " algorithm. " IEEE Journal on Selected Areas in Communications, 16 (2). pp. 140-152. ISSN 0733-8716.

LDPC Codes "compete" alongside Turbo codes for use in data transmission. Data packets encoded using LDPC codes can also be decoded using Belief Propagation based algorithms, but these algorithms are required to operate on the so-called Tanner Graph representation of an LDPC code, which is defined when the function nodes of the Factor Graph are parity check functions. Although BP algorithms are defined to compute locally the Bayes rule on a Factor Graph, the BP based algorithms used in decoding LDPC codes typically use a *"message passing"* algorithm on the Tanner graph, e.g. local message updates of the check nodes of the Tanner Graph can use bit flipping, min-sum, and lambda-min algorithms or the like.

More recently the so-called Group Belief Propagation algorithm has been used to decode LDPC codes over Abelian groups, see the paper by A. Goupil, M. Colas, G. Gelle, and D. Declercq, "FFT-based BP Decoding of General LDPC Codes over Abelian Groups ", to appear in the IEEE Trans. on Commun., 2007.

Both LDPC and Turbo codes are now used prevalently in communications systems and standards, e.g. in the latest wireless communications standards and systems such as IEEE 802.11n, IEEE 802.16e, ETSI DVB-S2 or the like, as there is a demand for communications devices, services and applications that operate over a wide range of communications systems. The result is that it is necessary to have an increasing amount of computational power, that is increasing the amount of (1) hardware required for a hardware based implementation, or (2) processing power required for a software based implementation, to cope with the different systems, quality of service levels, services and applications that are now provided.

As an example, multiple encoder and decoder circuits or chips may be required in a single communications device. This results in multiple encoder/decoder chip-sets being installed, each for use with a particular encoder and/or decoder. But, the proliferation of multiple chip-sets in each device results in an inefficient use of power, space and hardware usage especially for resource limited communications devices such as mobile handsets/terminals or the like.

Currently, Turbo and LDPC codes are becoming popular for use in data communication, but the corresponding decoders are so fundamentally different, that is Turbo Codes are primarily based on Factor Graph based decoding algorithms and LDPC codes are primarily based on Tanner Graph based decoding algorithms. The result, using the above example, is that two chip-sets are required to enable a communications device to use both of these types of codes, which increases power consumption together with the amount of space due to the die areas of the two chip-sets, thus increasing the size of the communications device. This is particularly a problem for mobile applications since the more complexity that is required the more power that is consumed, which is crucial in power limited systems.

Currently there is a need to reduce the current inefficient use of communications device resources (hardware or software), but at the same time retaining the ability to use both LDPC and Turbo Codes when required in a communications system.

SUMMARY OF THE INVENTION

The Applicant has realised an important concept in which both Turbo Codes and LDPC Codes are decoded based on a decoding algorithm that can re-use the same hardware resources. The applicant has further realised that the technique can be applied to any code, that is any forward error correcting code, that has a binary parity check matrix that is locally dense, for example Turbo-like codes such as parallel Turbo codes (PCCC), serial Turbo Codes (SCCC), and m-binary Turbo Codes.

As an example, when using Turbo Codes the Turbo decoder typically uses the BCJR algorithm, but the Applicant has found that this algorithm can be replaced with a Belief Propagation (BP) based decoding algorithm that uses a clustered version of a processed version of the binary parity check matrix of the Turbo-code when the Turbo-code is interpreted as a block code. Clustering the processed binary parity check matrix involves partitioning the binary parity check matrix into sub-matrices. It is important to note that the decoding algorithm operates on the Tanner Graph of the clustered binary parity check matrix.

The Applicant has realised that the encoding and/or the decoding of Turbo-codes can be modified, by processing the encoded data and/or the binary parity check matrix, or using code parameters for use with the decoding algorithm based on the Group Belief Propagation algorithm used for LDPC codes. This implies that for any code that has a binary parity check matrix that is locally dense, a decoding algorithm that is based on the Group Belief Propagation algorithm may be used provided the encoded data and/or binary parity check matrix are processed. Therefore, a decoding algorithm has been realised that can be used to decode both LDPC codes and, for example, Turbo Codes and other such codes with a locally dense binary parity check matrix.

Pre-processing at the receiver can be performed on the binary parity check matrix of a Turbo code, that is the binary image representation of a Turbo Code is modified for use with a decoding algorithm based on Group BP. Additionally, processing at the transmitter of the encoded data packet using appropriate linear matrix operations like interleaving or similarly matrix permutations can be used to ease the burden of processing at the receiver. The processing at the transmitter and/or at the receiver is the "keystone" for using a decoding algorithm based on BP such as Group BP.

The present invention provides a method and apparatus for allowing codes with locally dense binary matrices, e.g. Turbo and LDPC codes, to be decoded based on BP or Group BP, providing the advantage that only one set of resources, e.g. one decoding chip or decoding circuit, is necessary for receiving data encoded by a Turbo or LDPC code, and thus providing the advantages of improved power efficiency, space and device resource usage (e.g. hardware and/or software) with complexity limited communications devices.

An aspect of the invention provides a method for encoding and decoding at least one data packet in a communication system comprising a transmitter and a receiver, the method including encoding the data packet using an encoding scheme, processing the encoded data packet according to one or more predetermined permutations, receiving and decoding the processed encoded data packet using a decoder based on a Belief Propagation algorithm and the linear operations.

In a preferred embodiment of the invention, processing the encoded data packet is performed at the transmitter. In another preferred embodiment, processing the encoded data packet is performed at the receiver. Preferably, the linear operations are linear matrix operations.

An aspect of the invention provides a method for encoding and decoding at least one data packet in a communication system including a transmitter and a receiver, the method including encoding the data packet using an encoding scheme, processing the encoded data packet according to one or more predetermined permutations, transmitting the processed encoded data packet from the transmitter to the receiver, processing a binary parity check matrix of the encoding scheme used to encode the data packet based on linear matrix operations, decoding the received processed encoded data packet using a decoder based on a Belief Propagation decoding algorithm and the processed binary parity check matrix.

An aspect of the invention provides an apparatus for encoding at least one data packet including means for encoding the data packet, means for processing the encoded data packet based on one or more predetermined permutations, and means for transmitting the processed data packet, where a receiver means and decoding means receives and decodes the processed data packet using a decoding algorithm based on a Belief Propagation algorithm and one or more linear matrix operations.

Another aspect of the invention provides an apparatus for decoding at least one encoded data packet, the apparatus including means for receiving the encoded data packet, means for processing a binary parity check matrix of the encoding scheme used to encode the at least one data packet, means for processing the encoded data packet according to one or more predetermined binary permutations, means for decoding the at least one received encoded data packet using a decoding algorithm based on a Belief Propagation algorithm and the processed binary parity check matrix.

A preferred embodiment of the invention provides that the binary parity check matrix of the code used to encode the data packet is locally dense. In a preferred embodiment the code or encoding scheme used to encode the data packet is a Turbo code. This provides the advantage that both Turbo codes and LDPC codes can be decoded using the same set of device resources, for example the same chip sets and/or software resources. Further examples of Turbo codes include parallel Turbo Codes (PCCC), serial Turbo Codes (SCCC), m-binary Turbo Codes.

A preferred embodiment of the invention provides processing the binary parity check matrix of the code with a linear matrix operation that has been selected to reduce the probability or likelihood of cycles within a Tanner Graph of the clustered version of the processed binary parity check matrix as compared to the probability or likelihood of cycles within a Tanner Graph of the clustered version of the binary parity check matrix prior to processing. This provides improved performance in decoding the encoded data packet based on the Belief Propagation algorithm.

A preferred embodiment of the invention provides performing linear matrix operations on the binary parity check matrix, in which the linear matrix operations are based on permuting the rows of the binary parity check matrix, and/or permuting the columns of the binary parity check matrix, and/or other generalised linear matrix operations.

A preferred embodiment of the invention provides means for partitioning or clustering the processed binary parity check matrix into sub-matrices of size p>1 for use in the decoding algorithm based on BP. In another preferred embodiment, decoding algorithm based on the BP or Group BP algorithm operates on the Tanner Graph of the partitioned or clustered processed binary parity check matrix. Further embodiments of the invention provide the partitioning, or clustering, of the processed binary parity check matrix to be applied even if the size of the binary parity check matrix is not a multiple of the cluster size, p, or sub-matrix size, p.

A further aspect of the invention provides a computer program including computer code means adapted to perform substantially the methods, as described herein, in a communications system, transceiver, transmitter, receiver or other communications device or apparatus and the like, when said program is executed within said communications system, transceiver, transmitter, receiver or other communications device or apparatus and the like.

BRIEF DESCRIPTION OF THE DRAWINGS

Preferred features and embodiments of the invention will now be described, purely by way of example, with reference to the accompanying drawings, in which: -

Figure 1 illustrates a block representation of a Turbo Encoder suitable for encoding a data packet and a reciprocal Turbo Decoder suitable for decoding the encoded data packet according to a preferred embodiment of the invention.

Figure 2 illustrates another block representation of a Turbo Encoder for encoding a data packet and a reciprocal Turbo Decoder for decoding the encoded data packet according to another preferred embodiment of the invention.

Figure 3 illustrates the condition of a binary parity check matrix of a Turbo Code with recursive generator polynomials $(1, 23/35)_8$ and the condition of the processed (pre-processed or modified) binary parity check matrix of the Turbo Code suitable for use with the preferred embodiments of the invention.

Figure 4 illustrates the frame-error-rate performance for comparing the Turbo-Encoder/Decoder of the preferred embodiment given in Figure 1 resulting from using the processed binary parity check matrices illustrated in Figure 3.

Figure 5 illustrates the frame-error-rate performance of the Turbo decoder based on the BP algorithm and the modified binary parity check matrix of Figures 3 and 4 when the size of the sub-matrices or clusters, p, is increased.

DETAILED DESCRIPTION OF THE PREFERRED EMBODIMENTS

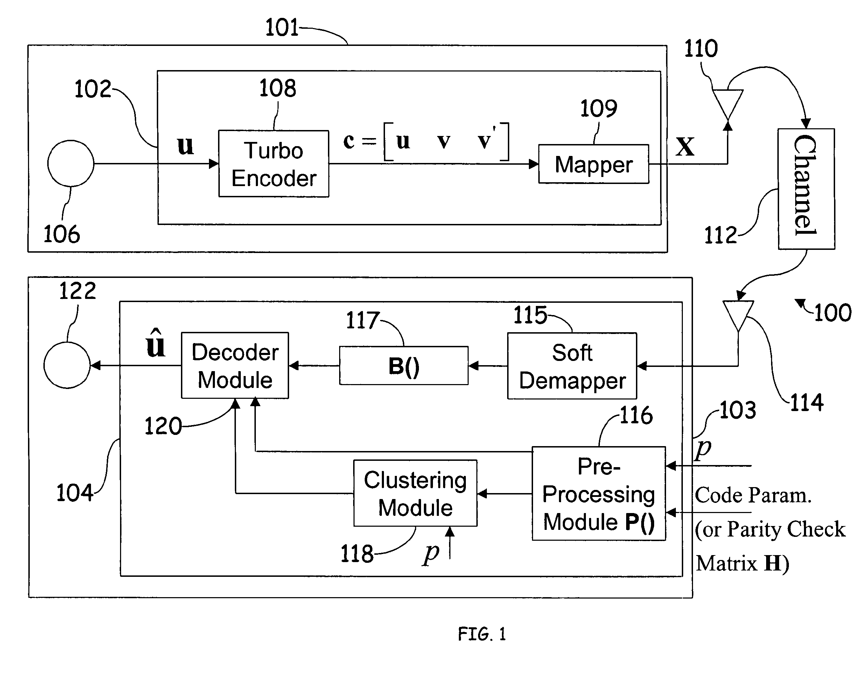

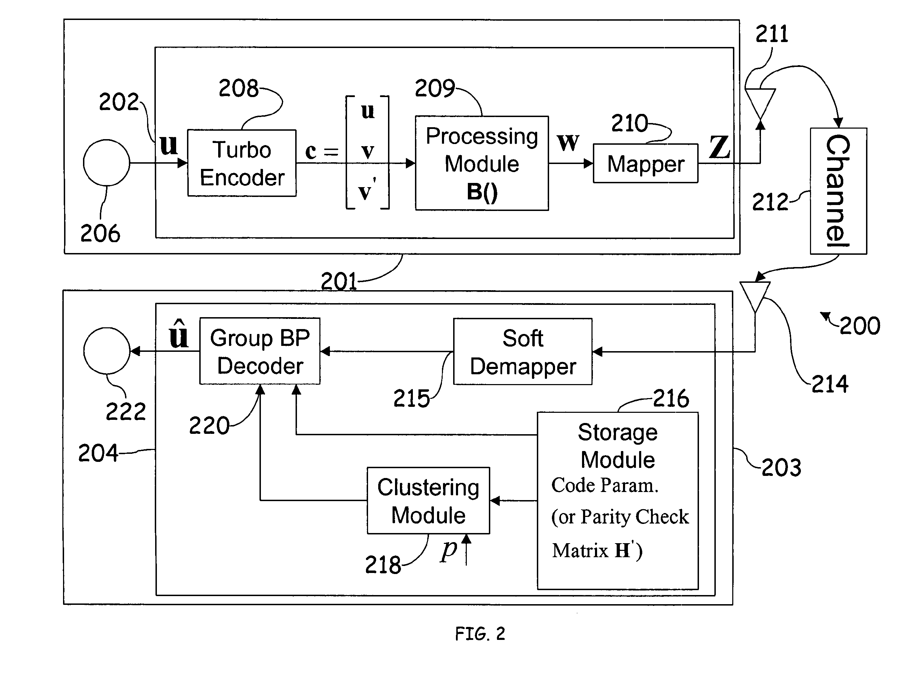

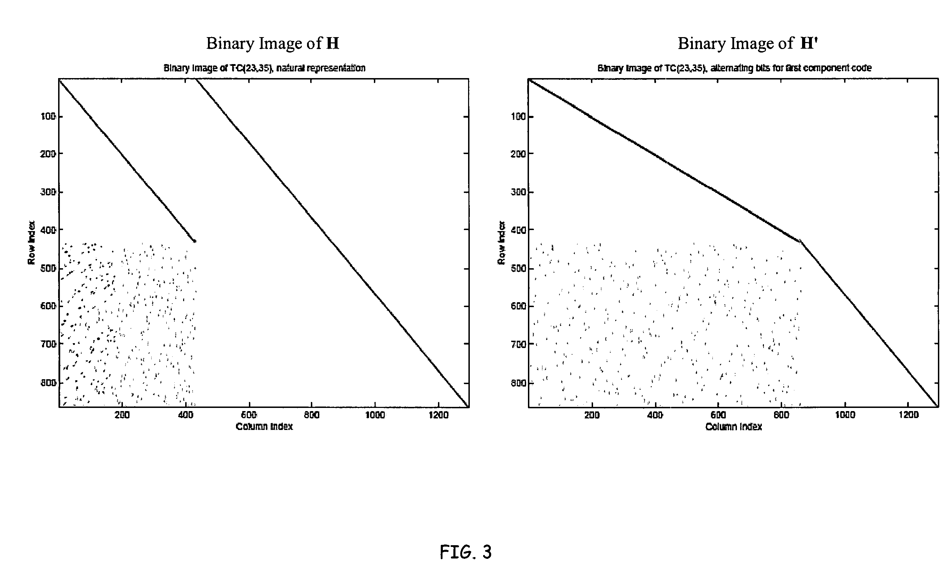

Figure 1 illustrates a simplified communications system 100 illustrating a preferred embodiment of the invention. A communications device 101 includes a portion of a transmitter unit 102 for encoding data packets for transmission in which a corresponding communications device 103 including a portion of a receiver unit 104 receives and decodes the encoded data packet transmission. Similarly, this is followed by a description of another simplified communications system 200 illustrating another embodiment of the invention as shown in Figure 2. Finally, a further illustration on the performance of the embodiments of the invention is provided in Figures 3 to 5. A brief overview of the communication system 100 is now given followed by a detailed description of its components.

Although the description of the preferred embodiments is given in relation to Turbo Codes, the principles described herein are not limited to Turbo Codes, in fact any code (i.e. any forward error correcting code) that has a binary parity check matrix that is locally dense may be applied in place of Turbo Codes, for example other Turbo codes such as parallel Turbo codes (PCCC), serial Turbo Codes (SCCC), or m-binary Turbo Codes or the like may be used.

Referring to Figure 1, the communications system 100 includes, for illustrative purposes, a communications device 101 that includes a data source 106, a portion of a transmitter unit 102 that encodes the data stream or packet $\mathbf{u} = [u_1,...,u_i...,u_k]$ using a Turbo Encoder 108, a Mapper 109 for modulating the encoded data packet for transmission, and an antenna 110 that communicates the encoded data packet $\mathbf{c}=[\mathbf{u},\mathbf{v},\mathbf{v'}]$ through a channel 112 to another communications device 103. The communications device 103 includes a receiver unit 104, the receiver unit 104 including a receive antenna 114, a Demapper 115, a pre-processing module 116, a processing module $\mathbf{B}_{()}$ 117, a clustering module 118, and a Decoder Module 120 that includes a decoding algorithm based on a BP or Group BP algorithm for decoding the received encoded data packet producing a data packet estimate $\hat{\mathbf{u}} = [\hat{u}_1,..., \hat{u}_i,..., \hat{u}_k]$ for data sink 122.

The transmitter unit 102 receives information bits (or a data packet) $\mathbf{u} = [u_1,..., u_i ,..., u_k]$ from data source 106, and a Turbo code encoder module 108 encodes the data bits into the code word $\mathbf{c} = [\mathbf{u}, \mathbf{v}, \mathbf{v}']$. The Turbo-code used can be a parallel (PCCC), serial (SCCC), m-binary or any other Turbo-Code. As an example, parallel Turbo Codes are a parallel concatenation of at least two convolutional codes in which the data bits $\mathbf{u} = [u_1,...,u_i,...,u_k]$ are transmitted as a systematic portion of the code word $\mathbf{c}$, (i.e. called the block of information bits at the input of the turbo-code), $\mathbf{v}$ is a first set of parity bits from a first encoder, (i.e. the block of redundancy bits at the output of the first component code), and v' is a second set of parity bits from a second encoder in which the input data bits $\mathbf{u} = [u_1,...,u_i,...,u_k]$ have been interleaved accordingly, (i.e. the block of redundancy bits at the output of the second component code). Typically the first and second encoders are convolutional, recursive convolutional, or recursive systematic convolutional encoders.

The encoded data packet $\mathbf{c} = [\mathbf{u},\mathbf{v},\mathbf{v}'] = [c_0, c_1,..., c_{N-1}]$, where $N$ is the length of the codeword, is mapped from coded bits into symbols of a suitable $M$-ary symbol constellation by Mapper 109, where $M = 2^m$ and $m = \log_2 (M)$ is the number of bits per symbol. The Mapper 109 maps groups of $m$ bits of $\mathbf{c}$ to one of the $M = 2^m$ symbols. The $i$-th group of bits is denoted $\bar{c}_i=[c_{i \cdot m},c_{i \cdot m+1},...,C_{i \cdot m+(m-1)}]$ for $0 \le i \le q -1$, where $q = N/m$ is assumed to be an integer. The grouped bits are denoted $\bar{c}=[c_0,c_1,...,c_{q-1}]$. The Mapper 109 then maps the groups of bits $\bar{c}_i$ to symbols using mapping function $f$ $(\cdot)$, where $x_i = f(\bar{c}_i)$ such that $x_i \in \chi$ alphabet of constellation, which results in $\mathbf{X} = f(\bar{\bar{c}}) = [f(\bar{c}_0),f(\bar{c}_1),...,f(\overline{c_{p-1}})]$. Examples of the various possible constellations include Quadrature Phase Shift Keying, $M$-ary-Quadrature Amplitude Modulation (QAM), $M$-ary Phase Shift Keying (PSK), $M$-ary Frequency Shift Keying (FSK) or any other $M$-ary constellation or the like.

The modulated encoded data packet $\mathbf{X}$ is then transmitted using antenna 110 over communications channel 112 and received by another communications device's 103 receiver unit 104. It is assumed that the transmit unit 102 has the required components (some of which are not shown) necessary for transmitting the encoded data packet over communications channel 112. For simplicity the communications channel 112 is assumed to be an Additive White Gaussian Noise channel (AWGN), but any type of communications channel is equally applicable.

The receiver unit 104 also has the corresponding components (some of which are not shown) necessary for receiving the encoded data packet, which is received by receive antenna 114. The received encoded data packet is denoted by $\mathbf{y} = a\mathbf{X} + \mathbf{n}$, where $\mathbf{y}$, $\mathbf{X}$, $\mathbf{a}$ and $\mathbf{n}$ may be complex numbers and $\mathbf{X} = f(\bar{\bar{c}}) = [x_0, x_1, ..., x_{q-1}]$ is the mapped encoded data packet that was transmitted over the communications channel 112, and $a$ and $n$ represent the effects of the channel (e.g. effects of fading, channel attenuation and AWGN) on transmission $\mathbf{X}$. The received data is demodulated/demapped by Soft Demapper 115, which outputs "soft" decisions, some of which will be described below, for input to Decoder Module 120. Inbetween the Soft Demapper 115 and Decoder Module 120 is a processing module $\mathbf{B}_{()}$ 117, which performs a permutation operation such that the channel Log-Likelihood Ratios are re-ordered depending on the processed binary parity check matrix H' based on linear matrix operations (to be discussed in detail below) that is from Pre-Processing Module $\mathbf{P}_{()}$ 116. Depending on the type of linear matrix operations performed on $\mathbf{H'}$, in some instances the permutation operation is simply an interleaver, but in other instances the permutation operation may not be performed, i.e. the permutation operation is based on an identity matrix.

The Soft Demapper 115 demaps and processes the received encoded data packet and outputs "soft" decisions such as channel Log-Likelihood Ratios (LLRs). There are many algorithms that are used for generating channel LLRs for output by the Soft Demapper 115 and for input to Decoder Module 120. Several examples of such algorithms for generating channel LLRs are the BCJR soft demapper, lower complexity Max-Log-Maximum A posteriori Probability (MAP) and Non-Iterative Demapper algorithms. Further details of various soft demapping algorithms are described in the papers, J. Speidel, S. ten Brink, and R. Yan, "Iterative demapping and decoding for multilevel modulation, " in Proc. IEEE Globecom Conf., Sydney, Australia, Nov. 1998, pp. 579-584, and G. Caire, G. Taricco, and E. Biglieri, "Bit-interleaved coded modulation, " IEEE Trans. Inform. Theory, vol. 44, pp. 927-946, May 1998.

The BCJR soft demapper algorithm is a well-known technique for dealing with iterative-bit-interleaved coded modulation iterative decoding (BICM) algorithms, and can be applied for use with the Soft Demapper 115 and/or the Decoder Module 120. This algorithm takes into account the feedback of a-priori knowledge that relates to the bits statistics. Typically, the output of the Soft Demapper 115 will be extrinsic LLRs that are based on a-posteriori bitwise LLRs. The a-posteriori LLRs result from the summation of the extrinsic LLRs output from the Soft Demapper 115 and a-priori knowledge (or known information) that is input to the Soft Demapper 115. There are many well-known algorithms that generate a-priori knowledge for re-injection into the Soft Demapper 115.

Alternatively, the Soft Demapper 115 and Decoder Module 120 can be arranged to implement an Iterative Turbo processing scheme, in which a-priori knowledge is re-injected into the Soft Demapper 115 in each iteration. Many other arrangements of the Soft Demapper 115 and Decoder Module 120 are also possible. In any case, "soft" decisions or channel LLRs are output by the Soft Demapper 115 and used with the decoding algorithms of the Decoder Module 120.

The "soft" decisions or channel LLRs output from the Soft Demapper 115 are processed further by processing module $\mathbf{B}_{()}$ 117, this permutes the output channel LLRs that are then input to the Decoder Module 120. The Decoder Module 120 provides the decoding algorithm that is based on a BP decoding algorithm to decode the channel LLRs. Preferably the BP algorithm that is used is based on a Group BP Decoding algorithm.

Further inputs to the Group Belief Propagation Decoder Module 120 come from the Processing Module 116 and the Clustering Module 118. The processing module 116 pre-processes the binary parity check matrix **H**, or code parameters, of the Turbo Code, that is the Turbo Code used to encode the data packet $u = [u_l,..., u_i,..., u_k]$, into a form suitable for decoding the channel LLRs generated by the Soft Demapper 115. The Clustering Module 118 partitions or creates clusters (of size p) of $p \times p$ sub-matrices that are used in the decoding algorithm based on the BP or Group BP algorithm of the Decoder Module 120, the details of which are briefly described below. After decoding using the Decoder Module 120, an estimate of the transmitted coded information is forwarded to a data sink 122.

There are essentially three steps for deriving a suitable decoding algorithm based on the BP and/or Group BP algorithms.

First, a binary parity check matrix **H** of size $(N - K \times N)$ of the Turbo-Code is generated or built with the knowledge of the Turbo encoder's structure, that is the generator polynomials, interleavers used, puncturing pattern, etc,.

The binary parity check matrix **H** results from the Generator matrix representation of the convolutional code, recursive convolutional codes, or recursive systematic convolutional code used for each particular type of Turbo code. The generator polynomials are used to derive the Generator matrix, which can be represented for recursive systematic convolutional codes in the following form:

$$G(D) = \begin{pmatrix} 1 & & & h_1^T(D)/h_c^T(D) \\ & 1 & & h_2^T(D)/h_c^T(D) \\ & & \ddots & \vdots \\ & & 1 & h_{c-1}^T(D)/h_c^T(D) \end{pmatrix}$$

The related parity check matrix **H** is generally given by:

$$H^T(D) = \begin{pmatrix} h_1^T(D) \\ h_2^T(D) \\ \vdots \\ h_c^T(D) \end{pmatrix}$$

The binary representation of the Turbo-code is given by the binary representation of the parity check matrix of the Turbo-code. The binary parity-check matrix **H** representation for a code word given in the form of **c** = **[u, v, v']** is:

$$H = \begin{bmatrix} H_2 & H_1 & 0 \\ H_2\Pi^T & 0 & H_1 \end{bmatrix}$$

In this case, **H$_2$** represents the systematic or information bits of the code word, and **H$_1$** represents the redundancy or parity bits part of the matrix representation of the constituent RSC code. The symbol **II** is the matrix permutation for the interleaving process between both constituent encoders. This binary matrix representation of the parity check matrix **H** is valid if the encoded data packet or bit stream is arranged in the form **c** = **[u, v, v']** , if $\mathbf{c} = \begin{bmatrix} \mathbf{u} \\ \mathbf{v} \\ \mathbf{v'} \end{bmatrix}$ , then the binary

parity check matrix **H** is simply transposed.

Secondly, the selection and/or calculation of a binary parity check matrix denoted by **H'** is performed to give improved performance. This matrix is dependent on the particular encoding scheme used at the transmitter, hence the receiver may be notified by the transmitter of the encoding scheme used to encode the data packet, so that the correct binary parity check matrix is processed and/or used. The binary parity check matrix **H'** is calculated by performing the operation **H' = P(H)**, where $\mathbf{P}_{()}$ is a functional block that performs linear operations on **H**. The binary parity check matrix **H'** is used in the decoding algorithm of Decoder Module 120. Preferably, the Processing Module 116 performs the operation **H'= P(H)**, in which **P(H)** is called a processing block that operates on binary parity check matrix H by performing linear operations. This will be described below in more detail. Alternatively, code parameters based on the linear operations and **H** can be used to derive the binary parity check matrix **H'**.

The matrix **H'** is also input to the Cluster module 118, where the matrix **H'** is clustered or partitioned into ($p \times p$) binary clusters or sub-matrices so that there are $(N - K)/p$ clusters or sub-matrices on the rows and $N/p$ clusters or sub-matrices on the columns. It is not necessary for the cluster size p to be a divisor of the size of **H'**. Typically, the performance of the BP algorithm or the Group BP algorithm used in the Decoder Module 120 improves for $p>1$ as less cycles form in the Tanner Graph based on the clustered binary parity check matrix **H'**.

Thirdly, the processed or selected matrix **H'** and the clustering of **H'** is input to the decoding algorithm that is based on the BP or Group BP algorithm. The decoding algorithm based on the BP or Group BP algorithms use the Tanner Graph of the clustered processed binary parity check matrix **H'**.

Note that there are two crucial parameters that affect the performance of the Decoder Module 120 based on the BP or Group BP decoding algorithm. The first parameter is the size $p$ of the clusters or sub-matrices, as this parameter tunes the decoding complexity/performance trade-off of the Decoder Module 120. The second parameter is the binary image of the binary parity check matrix **H**. The form of the binary image (binary representation) of the binary parity check matrix **H** is important since the unprocessed binary parity check matrix **H** as given above results in poor decoding performance when used in conjunction with the BP or Group BP decoding algorithm of the Decoder Module 120.

The selection and/or calculation of the binary image of the matrix **H** is one of the essential degrees of freedom that is of significant importance for decoding Turbo codes using a BP or Group BP algorithm. The optimising or processing **H** to give **H'** has a great impact on the performance of decoding the Turbo encoded data packet. The decoder behaviour based on the BP or Group BP algorithms are very different once the binary parity check matrix **H** has been optimised, modified or pre-processed giving **H'** , which is then clustered in the Clustering module 118.

Depending on the binary representation of the binary parity check matrix **H**, the decoding algorithm based on the BP or Group BP algorithms could either have performance close to the a Turbo-decoder decoding the same Turbo Code using the BCJR algorithm, or either loose several dBs in performance due to a poor determination, choice, selection, or calculation of **H'**. Applying the decoder based on the BP or Group BP algorithm on transmissions using Turbo-codes, the Processing Module 116 includes a pre-processing block $\mathbf{P}_{()}$ that is used to calculate or pre-process the binary parity check matrix **H** to give **H'**. This module then outputs the processed or optimised binary parity check matrix **H' =P(H)**, where $\mathbf{P}_{()}$ operates on **H** using linear matrix operations. Once pre-processing is complete, **H'** is input to the Decoder Module 120, which, if the pre-processing block $\mathbf{P}_{()}$ has been correctly selected/optimised, will result in improved performance than if the original binary parity check matrix **H** were input to the Decoder Module 120. It is the purpose of the pre-processing block $\mathbf{P}_{()}$ to form a binary parity check matrix **H'** that is optimised, or gives improved performance, for use with the particular Turbo-Code used to encode the data packet. Typically, the transmitter notifies the receiver of the encoding scheme used to encode the data packet. The receiver can also have additional functionality, e.g. in hardware or software, that detects the particular encoding scheme used. Alternatively, there may be a standard protocol set-up as to the encoding scheme that is used and thus the selection or processing of **H** to get **H'** is defined by that standard protocol.

The pre-processing block $\mathbf{P}_{()}$ operates on the binary parity check matrix **H** using linear matrix operations that, depending on the particular Turbo Code, include column and/or row permutations, or row linear operations, or any other useful matrix operation, such as multiplication of a weighted linear matrix.

As an example, let **H** be the binary parity check matrix corresponding to the particular or the chosen encoding scheme (standard or else) and let $\mathbf{H'} = \mathbf{P(H)} = \mathbf{A} \cdot (\mathbf{H}) \cdot \mathbf{B}^{\mathbf{T}}$ , where $\mathbf{B}^{\mathbf{T}}$ is a transposition of a permutation matrix (column permutation) and **A** is a general matrix that could be restricted to a permutation matrix or not.

In this case, **H'** is the pre-processed binary parity check matrix that is used for the decoder based on the BP or Group BP algorithm. The pre-processing block **P(H)** performs linear matrix operations that include the permutation of columns of **H** or other more general linear functions. The pre-processing should be performed on **H** (the binary image of the code) before the clustering operation of Clustering Module 118. The above-mentioned pre-processing does not change the code space nor does it change the size of the Tanner graph representation of the code. As well, if the cluster size is $p = 1$, a pre-processing limited to row or column permutation does not change the decoder convergence and all binary images of the parity check matrix are decoded equivalently.

The linear matrix operations that are used in the pre-processing block $\mathbf{P}_{()}$ to process a particular binary parity check matrix **H** for a particular code, which the receiver may have been notified of by the transmitter prior to transmission of the encoded data packet, are usually predetermined or stored within the receiver. The matrix linear operations have been defined beforehand, when designing or selecting an appropriate matrix **H'**. The appropriate selection of **H'** and the linear matrix operations used to derive/calculate **H'** is dependent on the particular code or encoding scheme, e.g.

Turbo code, used to encode the data packet for transmission.

The matrix operations used in pre-processing block $\mathbf{P}_{()}$ are determined by searching for one or more matrix operations like row or column permutations and/or a general linear operations , such that the probability or likelihood of cycles in a Tanner Graph of the clustered version of the processed binary parity check matrix **H'** is less than, or below a certain threshold of, that of the probability or likelihood of cycles in a Tanner Graph of the original or unprocessed clustered version of the binary parity check matrix **H**, i.e. the clustered version of the binary parity check matrix **H** of the Turbo code prior to processing.

Another technique for determining an appropriate pre-processing block $\mathbf{P}_{()}$ is to select matrix linear operations to be performed on **H** that result in the frame or bit error rate at the output of the decoder based on the BP or Group BP algorithms that use **H'=P(H)** being less than the frame or bit error rate of the decoder based on the BP or Group BP algorithm that uses **H**, i.e. the unprocessed binary parity check matrix.

Naturally, other criteria can be used to search for an appropriate combination of linear matrix operations for use in pre-processing block $\mathrm{P}_{()}$ that will result in an optimised or suitable **H'** for a decoder based on the BP or Group BP decoding algorithm for use in Decoder Module 120.

The decoding algorithm of the Decoder Module 120 is based on a BP algorithm or the Group BP algorithm. The pre-processed or optimised parity check matrix **H',** cluster size p, and clusters or sub-matrices of **H'** are input to the Decoder Module 120, where one or more iterations of the decoding algorithm based on the BP or Group BP algorithm are run on the Tanner Graph of the clustered version of **H'**. The Group BP algorithm as presented in the paper by A. Goupil, M. Colas, G. Gelle and D. Declercq, "FFT-based BP Decoding of General LDPC Codes over Abelian Groups, " to appear in the IEEE Trans. on Commun., 2007, is an example of an appropriate BP algorithm for use with the decoding algorithm of Decoder Module 120. Note that the Decoder Module 120 acts on clusters that are general linear functions, and not only cyclic permutations, so that the clustering of the pre-processed binary parity check matrix **H'** leads to a parity check code defined on a finite Abelian Group $G(2^p)$ instead of a Galois Field $GF(2^p)$.

Referring now to Figure 1, another preferred embodiment of the invention is now described. In this embodiment the transmitting communications device 201 processes the encoded data packet by, among other things, permuting or interleaving the encoded data packet before transmission. This eases the burden of processing performed at the receiving communications device 203. A brief overview of the communication system 200 is now given followed by a detailed description of its components.

Referring now to Figure 2, the communications system 200 includes, for illustrative purposes, a communications device 201 that includes a data source 206, a portion of a transmitter unit 202 that encodes the a data stream or packet $\mathbf{u}=[u_l,...,u_i,...,u_k]$ using a Turbo Encoder 208. The encoded data packet $\mathbf{c}=[\mathbf{u}, \mathbf{v},\mathbf{v'}]$ or codeword is then processed using a Processing Module 209 resulting in a processed codeword **w**, a Mapper 210 for modulating the codeword **w** for transmission, and an antenna 211 that communicates the codeword **w** through a channel 212 to another communications device 203.

The communications device 203 includes a receiver unit 204, the receiver unit 204 including a receive antenna 214, a Soft Demapper 215, a Storage Module 216 for storing code parameters or a predetermined processed parity check matrix **H'**, a Clustering Module 218, and a Decoder Module 220 that includes a decoding algorithm based on a BP or Group BP algorithm for decoding the received encoded data packet producing a data packet estimate $\mathbf{\hat{u}} = [\hat{u}_1, ..., \hat{u}_i, ..., \hat{u}_k]$ for data sink 222.

The transmitter unit 202 receives information bits (or a data packet) $\mathbf{u} = [u_1,...,u_i,...,u_k]$ from data source 206. As has already been described with respect to Figure 1, a Turbo Code encoder module 208 encodes the data bits into the code word $\mathbf{c} = [\mathbf{u}, \mathbf{v}, \mathbf{v'}]$. But, the codeword **c** is now processed by Processing Module 209 resulting in a codeword $\mathbf{w=B(c)}$, which is a codeword of matrix **H'**. The processing block **B** is limited to the part of the pre-processing $\mathbf{P}_{()}$ limited to column permutations. The receiver unit 204 needs to have an appropriate predetermined matrix **H'** or the relevant code parameters stored in Storage Module 216 that corresponds to the new codeword w for use in decoding the noisy version of the received codeword **w**. Note, processing block $\mathbf{B}_{()}$ might be different from permutations used to solve other transmission issues that rely on a permutation at the transmitter unit 202 (e.g. non stationary channel, etc).

The processed codeword $\mathbf{w} = \mathbf{B(c)}$ which is $N$ bits, is mapped from coded bits into symbols of a suitable $M$-ary symbol constellation by Mapper 210, where $M = 2^m$ and $m = \log_2 (M)$ is the number of bits per symbol. The Mapper 210 maps groups of $m$ bits of **w** to one of the $M = 2^m$ symbols. The $i$-th group of bits is denoted $\overline{w}_i =[w_{i\cdot m}, w_{i\cdot m+1},...,w_{i\cdot m+(m-1)}]$ for $0 \leq i \leq q\text{-}1$, where $q = N / m$ is assumed to be an integer. The grouped bits are denoted $\overline{\overline{w}} = [\overline{w}_0, \overline{w}_1,...,\overline{w}_{q-1}]$.

The Mapper 210 then maps the groups of bits $\overline{w}_i$ to symbols using mapping function $f(\cdot)$ , where $z_i = f(\overline{w}_i)$ such that $z_i \in \chi$ alphabet of constellation, which results in $\mathbf{Z} = f(\overline{w}) = [f(w_0), f(w_1), ..., f(w_{p-1})]$. Examples of the various possible constellations include Quadrature Phase Shift Keying, $M$-ary-Quadrature Amplitude Modulation (QAM), $M$-ary Phase Shift Keying (PSK), $M$-ary Frequency Shift Keying (FSK) or any other $M$-ary constellation or the like.

The modulated encoded data packet **Z** is then transmitted using antenna 211 over communications channel 212 and received by another communications device's 203 receiver unit 204. It is assumed that the transmit unit 202 has the required components (some of which are not shown) necessary for transmitting the encoded data packet over communications channel 212. For simplicity the communications channel 212 is assumed to be an Additive White Gaussian Noise channel (AWGN), but any type of communications channel is equally applicable.

The modulated codeword **Z** is transmitted from transmitter unit 202 using antenna 211 over communications channel 212 and is received by another communications device's 203 receiver unit 204. It is assumed that the transmit unit 202 has the required components (some of which are not shown) necessary for transmitting the encoded data packet via communications channel 212. For simplicity the communications channel 212 is assumed to be an Additive White Gaussian Noise channel (AWGN), but any type of communications channel is applicable.

The receiver unit 204 also has the corresponding components (some of which are not shown) necessary for receiving the modulated codeword Z, which is received by receive antenna 214. The received encoded data packet is **y** = $a$**Z** + $n$, where **y**, **Z**, a, and n may be complex numbers and **Z**=$f(\overline{w})$=$[z_0, z_1, ..., z_{p-1}]$ is the mapped codeword **w** that was transmitted over the communications channel, where $a$ and $n$ represent the effects of the channel, as has already been described in relation to Figure 1. The received data is demodulated/demapped by Soft Demapper 215, which outputs soft decisions based on channel LLRs for input to the Decoder Module 220. The channel LLRs, as described above, are calculated and output by the Soft Demapper 115 of Figure 1, or for that matter by any soft demapper or demapping algorithm. Decoder Module 220 provides the decoding algorithm that is based on a BP decoding algorithm to decode the channel LLRs. Preferably, the BP algorithm used is based on a Group BP Decoding algorithm.

Further inputs to the Decoder Module 220 come from the Storage Module 216 and the Clustering module 218. The Storage Module 216 has the binary parity check matrix **H'**, or code parameters thereto, of the Turbo Code equivalent to the codeword **w**, in a form suitable for decoding soft decision based on channel LLRs output from Soft Demapper 215. The decoding algorithm based on the BP or Group BP algorithm is used. The Clustering Module 218 partitions or creates clusters (of size p) of $p \times p$ sub-matrices that are used in the decoding algorithm based on the BP or Group BP algorithm of the Decoder Module 220. Details of which have already been discussed with reference to Figure 1. After decoding using the Decoder Module 220, an estimate of the transmitted coded information is forwarded to a data sink 222.

In an alternative embodiment, referring to the relevant components of Figures 1 and 2 and their description thereof, the transmitter encodes the data **u** into a codeword **c**, as is done using transmitter 102 of Figure 1. A processing block **B**$_{()}$ performs processing on the soft decisions based on channel LLRs output from the Soft Demapper 115 or 215. The Soft Demapper 115 or 215 outputs channel LLRs, which are input to a Decoder Module 220 that provides the decoding algorithm based on a BP or Group BP decoding algorithm to decode the channel LLRs.

Once again, the channel LLRs are input to the Decoder Module 220 along with inputs from the Storage Module 216 and the Clustering module 218. The Storage Module 216 has the binary parity check matrix **H'**, or code parameters thereto, of the Turbo Code equivalent to the codeword **w=B(c)**, in a form suitable for decoding the channel LLRs using the decoding algorithm based on the BP or Group BP algorithm. The Clustering module 218 partitions or creates clusters (of size p) of $p \times p$ sub-matrices that are used in the decoding algorithm based on the BP or Group BP algorithm of the Decoder Module 220. Details of which have already been discussed with reference to Figure 1. After decoding using the Decoder Module 220, an estimate of the transmitted coded information is forwarded to a data sink 222.

The BP algorithm that is used is based on a Group BP Decoding algorithm. Note that the choice of **B**$_{()}$, like the selection or choice of pre-processing block **P**, is again crucial to ensure the Decoder Module 220 based on the BP or Group BP algorithm can decode the encoded data packet.

The decoder complexity for a decoding algorithm based on a BP or Group BP decoding algorithm grows exponentially with cluster size $p$ compared to the BCJR Turbo-decoder algorithm, which complexity grows exponentially with ν, i.e. the constraint length of the constituent convolutional code. For some parameter values, the BP or Group BP decoding algorithm is then less complex than the BCJR Turbo-decoder algorithm, even when sub-optimal hardware implementation of the decoders are considered.

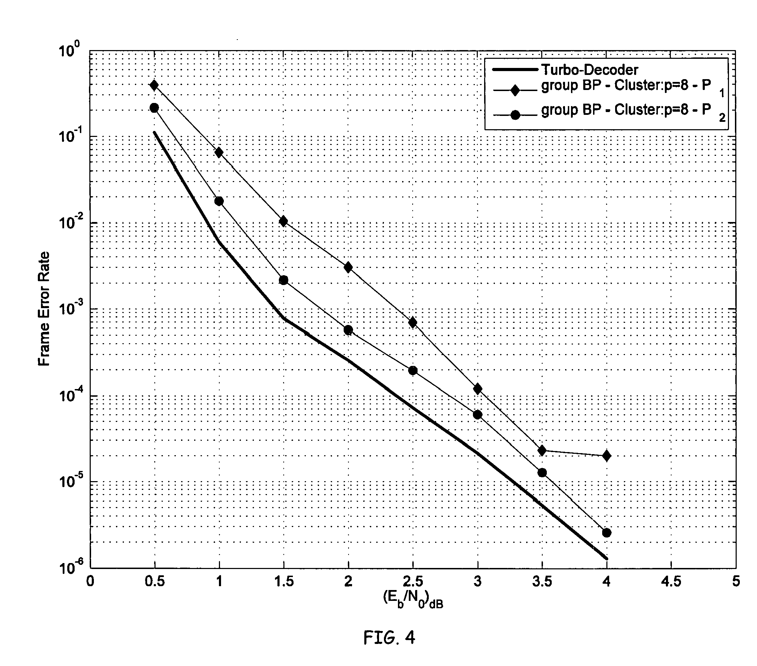

Referring now to Figures 3 and 4, the performance of the Group BP decoding algorithm is shown for a particular Turbo Code when **H** and **H'** are input to the Decoder Module 120 as described with reference to Figure 1. Figure 3 shows an illustration of the binary image of the parity check matrix **H** for the Turbo-code with recursive generator polynomials $(1, 23/35)_8$ is shown on the left of Figure 3 and an illustration of a binary image of a pre-processed parity check matrix **H'** is shown on the right of Figure 3. The interleaver size of K = 432 has been chosen-*"randomly* simply to illustrate the performance improvement of using **H'** instead of **H** in a Group BP decoding algorithm. Interleavers with very low minimum distance have been avoided as a matter of course. The obtained Turbo Code is a rate *R = 1/3,* that is 1 information bit for every 2 systematic bits. The minimum distance of the Turbo Code is computed using the impulse method as $D_{min}$ = 15.

Figure 4 shows the results of the simulated performance graph of frame error rate (FER) vs $(E_b/N_0)_{dB}$ for **H** and **H'** used in which the cluster size $p$ = 8. The performance of the two resulting decoders is compared with the BCJR Turbo-Decoding algorithm. It is clear from these plots that the choice of the pre-processing has a positive impact on the performance of the Group BP decoding algorithm. The optimisation of the pre-processing function, i.e. the determination of **H'**, shows a first possible solution of a pre-processing matrix or function to determine **H'** that performs within fractions of dB of the BCJR Turbo-Decoding algorithm.

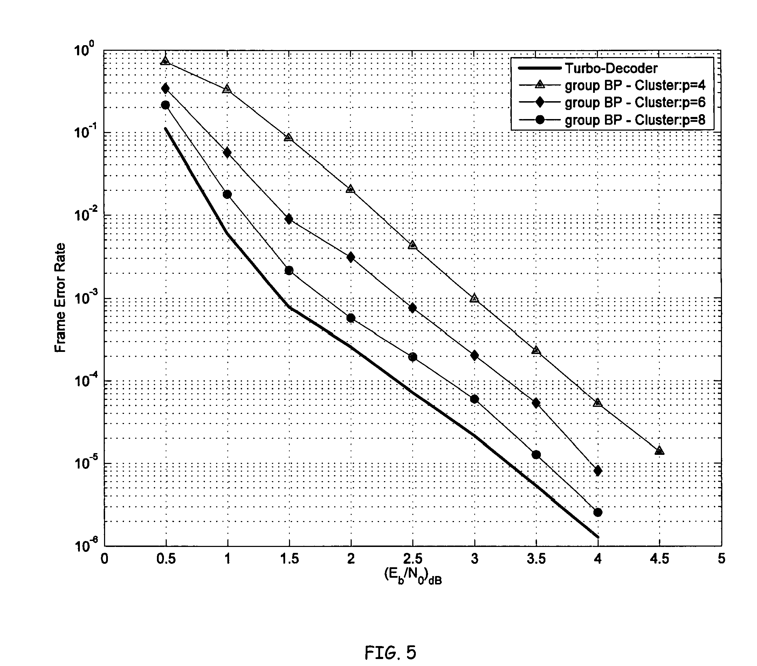

Referring now to Figure 5, a performance graph of the frame error rate (FER) vs $(E_b/N_0)_{dB}$ for the pre-processing function **H'** with different cluster sizes p = {4, 6, 8} is shown. It can be seen that as p increases, the performance of the Group BP decoding algorithm improves towards that of the BCJR Turbo-Decoding algorithm.

The adaptation of a communications systems or transceiver can be achieved by implementing embodiments, or portions thereof, of the invention in hardware such as any hardware means, computers, processors, circuits, Application Specific Integrated Chips or Field Programmable Gate Arrays and the like or firmware and the like, or software and the like, or any combination thereof.

In addition, a computer program may be included within the communications system or in portions of a computer program within the related network elements, and entities or transceivers of the communications system, which each include computer code means adapted to perform the required functions in relation to the method of encoding and decoding data packets transmitted and received between transceivers i.e. at least the functions of determining a modulation strategy for use in retransmitting one or more portions of a data packet and using these strategies by storing them for use in transmitting and processing one or more portions of a data packet.

The demapper not limited to using only the BCJR, BICM, or MAP algorithms, it is envisaged that any other demapping algorithm that can take as input apriori information and output extrinsic information can be used or substituted for the demapping algorithms described herein. Furthermore, the present invention is not limited to only using a soft-demapper module or algorithm, for example, the demapper can include a hard demapping algorithm that can take/use apriori information as input and may output extrinsic information that is derived from the hard symbol output of the hard demapping algorithm.

It can be seen that any modulation constellation may be used, i.e. M-ary QAM or PSK and the like. Similarly, any other modulation labelling and the like may be used in addition to those already mentioned.

It will be apparent from the foregoing that many other embodiments or variants of the above are possible. The present invention extends to any and all such variants, and to any novel subject matter or combination thereof disclosed in the foregoing.

**Claims**

1. A method for encoding and decoding at least one data packet in a communication system comprising a transmitter and a receiver, the method comprising the steps of:

   a) encoding the data packet using an encoding scheme;
   b) processing the encoded data packet according to one or more predetermined binary permutations;
   c) receiving and decoding the processed encoded data packet using a decoder based on a Belief Propagation algorithm and one or more linear matrix operations.

2. The method of claim 1, wherein the step of processing the encoded data packet is performed at the transmitter.

3. The method of claim 1, wherein the step of processing the encoded data packet is performed at the receiver.

4. The method of claim 3, wherein the encoded data is processed based on channel log-likelihood-ratios at the output of a soft demapper.

5. The method of any preceding claim, comprising the step of notifying the receiver of the encoding scheme used to encode the data packet.

6. The method of any preceding claim, wherein the receiver operates with the binary parity check matrix determined by processing the binary parity check matrix of the encoding scheme with the linear matrix operations.

7. The method of claim 6, wherein the processed binary parity check matrix is partitioned into sub-matrices of size *p>1* for use in the decoder based on the Belief Propagation algorithm.

8. The method of any of claims 6 or 7, wherein processing the binary parity check matrix further comprises processing the binary parity check matrix using one or more of the linear matrix operations selected to reduce the probability or likelihood of cycles in the Tanner Graph of a clustered version of the processed binary parity check matrix as compared with the probability or likelihood of cycles in the Tanner Graph of a clustered version of the binary parity check matrix prior to processing.

9. The method of any of claims 6 to 8, further comprising storing the processed binary parity check matrix in a storage medium.

10. The method of any preceding claim, wherein the BP algorithm is based on a Group Belief Propagation algorithm.

11. The method according to any preceding claim, wherein the one or more linear matrix operations are predetermined.

12. A method for encoding and decoding at least one data packet in a communication system comprising a transmitter and a receiver, the method comprising the steps of:

   a) encoding the data packet using an encoding scheme;
   b) processing the encoded data packet according to one or more predetermined binary permutations;
   c) transmitting the processed encoded data packet from the transmitter to the receiver;
   d) processing a binary parity check matrix of the encoding scheme used to encode the data packet based on linear matrix operations;
   e) decoding the received processed encoded data packet using a decoder based on a Belief Propagation decoding algorithm and the processed binary parity check matrix.

13. The method of claim 12, wherein the step of processing the binary parity check matrix based on linear matrix operations further comprises permuting the rows of the binary parity check matrix.

14. The method of claims 12 or 13, wherein the step of processing the binary parity check matrix based on linear matrix operations further comprises permuting the columns of the binary parity check matrix.

15. The method of any of claims 12 to 14, wherein the step of processing the binary parity check matrix is based on linear matrix operations further comprises linear combination of the rows of the binary parity check matrix.

16. The method of any of claims 12 to 15, wherein the step of processing further comprises partitioning the binary parity check matrix into sub-matrices of size $p>1$.

17. The method of any of claims 12 to 16, wherein the step of processing the binary parity check matrix further comprises processing the binary parity check matrix based on linear matrix operations selected to reduce the probability or likelihood of cycles in the Tanner Graph of the clustered version of the processed binary parity check matrix as compared with the probability or likelihood of cycles in the Tanner Graph of clustered version of the binary parity check matrix prior to processing.

18. The method of any of claims 12 to 17, further comprising storing the processed binary parity check matrix in a storage medium for future reference.

19. The method of any of claims 12 to 18, wherein decoding the encoded data packet further comprises a decoding algorithm based on a Group Belief Propagation algorithm.

20. The method of any of claims 12 to 19, comprising the step of notifying the receiver of the encoding scheme used to encode the data packet.

21. An apparatus for encoding at least one data packet comprising:

   means for encoding the data packet;
   means for processing the encoded data packet based on one or more binary permutations, and
   means for transmitting the processed data packet;
   wherein receiver means and decoding means are provided to receive and decode the processed encoded data packet using a decoder based on a Belief Propagation algorithm and one or more linear matrix operations.

22. The apparatus of claim 21, wherein the means for processing further comprises an interleaver for interleaving the encoded data packet.

23. The apparatus of claims 21 or 22, further comprising means for processing the encoded scheme's binary parity check matrix, wherein the probability or likelihood of cycles within a Tanner Graph of a clustered version of the modified binary parity check matrix is less than the probability or likelihood of cycles within a Tanner Graph of the clustered version of the binary parity check matrix prior to processing.

24. The apparatus of any of claims 21 to 23, further comprising means for notifying the decoding means of the encoding scheme used to encode the data packet.

25. The apparatus of any of claims 21 to 23, wherein the Belief Propagation algorithm is based on a Group Belief Propagation algorithm.

26. An apparatus for decoding at least one encoded data packet, comprising:

    means for receiving the encoded data packet;
    means for processing a binary parity check matrix of the encoding scheme used to encode the at least one data packet;
    means for processing the encoded data packet according to one or more predetermined binary permutations
    means for decoding the at least one received encoded data packet using decoder based on a Belief Propagation algorithm and the processed binary parity check matrix.

27. The apparatus of claim 26, wherein the means for processing the binary parity check matrix further comprises means for performing linear matrix operations on the binary parity check matrix.

28. The apparatus of claim 27, wherein the means for performing linear matrix operations further comprises means for permuting the rows of the binary parity check matrix.

29. The apparatus of claims 27 or 28, wherein the means for performing linear matrix operations further comprises means for permuting the columns of the binary parity check matrix.

30. The apparatus of any of claims 26 to 29, wherein the means for performing linear matrix operations further comprises means for performing linear combination of the rows of the binary parity check matrix.

31. The apparatus of any of claims 26 to 30, wherein the means for processing further comprises means for partitioning the binary parity check matrix into sub-matrices of size $p > 1$.

32. The apparatus of any of claims 26 to 31, wherein the means for processing the binary parity check matrix uses linear matrix operations selected to reduce the probability or likelihood of cycles in a Tanner Graph of the clustered version of the processed binary parity check matrix as compared to the probability or likelihood of cycles in a Tanner Graph of the clustered version of the binary parity check matrix prior to processing.

33. The apparatus of any of claims 26 to 32, further comprising storing means for storing the processed binary parity check matrix for future reference.

34. The apparatus of any of claims 26 to 33, wherein the means for decoding the encoded data packet further comprises means adapted to implement a Group Belief Propagation algorithm.

35. A communications system comprising one or more transmitters adapted to implement the related method steps of any of claims 1 to 20.

36. A transceiver adapted to implement the method of transmitting and receiving encoded data in a communications system of any of claims 1 to 20.

37. A transmitter substantially as hereinbefore described with reference to any of Figures 1 to 5 of the accompanying drawings.

38. A receiver substantially as hereinbefore described with reference to any of Figures 1 to 5 of the accompanying drawings.

**39.** A communications system substantially as hereinbefore described with reference to any of Figures 1 to 5 of the accompanying drawings.

**40.** A computer program comprising computer code means adapted to perform the method of any of claims 1 to 20 in relation to a transmitter or receiver when said program is run on the transmitter or receiver.

**41.** A computer program comprising computer code means adapted to perform the method of any of claims 1 to 20 in relation to a communications system when said program is executed within said communications system.

FIG. 1

FIG. 2

FIG. 3

FIG. 4

FIG. 5

**European Patent**
**Office**

**PARTIAL EUROPEAN SEARCH REPORT**

which under Rule 45 of the European Patent Convention
shall be considered, for the purposes of subsequent
proceedings, as the European search report

Application Number

EP 07 29 0233

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HAIYAN CAO ET AL: "Iterative decoding for LDPC coded DUSTM over flat Rayleigh fading channel" COMMUNICATIONS AND INFORMATION TECHNOLOGY, 2005. ISCIT 2005. IEEE INTERNATIONAL SYMPOSIUM ON BEIJING, CHINA OCT. 12-14, 2005, PISCATAWAY, NJ, USA, IEEE, 12 October 2005 (2005-10-12), pages 105-107, XP010875626 ISBN: 0-7803-9538-7 | 1,21,35, 36,40,41 | INV. H03M13/29 ADD. H04L1/00 |
| A | * section II ** figure 1 * ----- | 2-20, 22-34 | |
| X | US 2004/057575 A1 (ZHANG TONG [US] ET AL) 25 March 2004 (2004-03-25) * paragraphs [0023], [0046], [0047], [0080] * ----- | 1-36,40, 41 | |
| A | US 7 181 676 B2 (HOCEVAR DALE E [US]) 20 February 2007 (2007-02-20) * column 4, lines 58-62 * * column 1, lines 41-47 * * column 5, lines 6-11 * ----- | 7,16,31 | |

**TECHNICAL FIELDS SEARCHED (IPC)**

H04L
H03M

## INCOMPLETE SEARCH

The Search Division considers that the present application, or one or more of its claims, does/do not comply with the EPC to such an extent that a meaningful search into the state of the art cannot be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| Munich | 10 September 2007 | AGUDO CORTADA, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C07)

**European Patent**
**Office**

**INCOMPLETE SEARCH**
**SHEET C**

Claim(s) searched completely:
    1-36, 40-41

Claim(s) not searched:
    37-39

Reason for the limitation of the search:

Claims 37-39 are merely defined by the reference to any of the drawings.
The scope of protection of these claims and consequently the technical
features to be searched are to such extent unclear that no relevant
search can be performed (see Article 84 EPC, Rule 29(6) EPC and
Guidelines C-III 4.10)

**EP 1 962 430 A1**

## ANNEX TO THE EUROPEAN SEARCH REPORT
## ON EUROPEAN PATENT APPLICATION NO.

EP 07 29 0233

10-09-2007

| Patent document cited in search report | | Publication date | Patent family member(s) | | Publication date |
|---|---|---|---|---|---|
| US 2004057575 | A1 | 25-03-2004 | NONE | | |
| US 7181676 | B2 | 20-02-2007 | EP | 1779524 A1 | 02-05-2007 |
| | | | KR | 20070029846 A | 14-03-2007 |
| | | | US | 2006015802 A1 | 19-01-2006 |
| | | | WO | 2006020205 A1 | 23-02-2006 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MCELIECE, ROBERT J. ; MACKAY, DAVID J. C. ; CHENG, JUNG-FU.** Turbo decoding as an instance of Pearl's ''belief propagation '' algorithm. *IEEE Journal on Selected Areas in Communications,* 1998, vol. 16 (2), ISSN 0733-8716, 140-152
- **A. GOUPIL ; M. COLAS ; G. GELLE ; D. DECLER-CQ.** FFT-based BP Decoding of General LDPC Codes over Abelian Groups. *IEEE Trans. on Commun.,* 2007
- **J. SPEIDEL ; S. TEN BRINK ; R. YAN.** Iterative demapping and decoding for multilevel modulation. *Proc. IEEE Globecom Conf.,* November 1998, 579-584

- **G. CAIRE ; G. TARICCO ; E. BIGLIERI.** Bit-interleaved coded modulation. *IEEE Trans. Inform. Theory,* May 1998, vol. 44, 927-946
- **A. GOUPIL ; M. COLAS ; G. GELLE ; D. DECLER-CQ.** FFT-based BP Decoding of General LDPC Codes over Abelian Groups. *the IEEE Trans. on Commun.,* 2007